# EUROPEAN PATENT SPECIFICATION

(11) **EP 4 055 339 B1**
(45) Date of publication and mention of the grant of the patent: **06.12.2023**
(21) Application number: 20803785.3
(22) Date of filing: 06.11.2020
(51) Int. Cl.: F04B 17/00, F04B 19/00, F28F 13/16

(54) **ELECTROHYDRODYNAMICS SYSTEM AND METHOD**
ELEKTROHYDRODYNAMISCHES SYSTEM UND -VERFAHREN
SYSTÈME ET PROCÉDÉ ÉLECTROHYDRODYNAMIQUE

(30) Priority: 08.11.2019 SE 1951280
(43) Date of publication of application: 14.09.2022
(73) Proprietor: APR Technologies AB, 745 39 Enköping (SE)
(72) Inventor: ANTELIUS, Mikael, 187 51 TÄBY (SE); LÖFGREN, Henrik, 752 37 UPPSALA (SE); BJÖRNEKLETT, Are, 723 55 VÄSTERÅS (SE); NILSSON, Peter, 174 46 SUNDBYBERG (SE); THORSLUND, Robert, 193 91 SIGTUNA (SE)
(74) Representative: AWA Sweden AB
(86) International application number: PCT/EP2020/081239
(87) International publication number: WO 2021/089757

(56) References cited:
- EP-A1- 3 304 589
- GB-A- 1 274 875
- US-A- 4 396 055
- US-A1- 2017 138 901

## Description

### TECHNICAL FIELD

The present invention relates to electrohydrodynamics (EHD), and more specifically to the use of EHD for thermal management of heat generating components.

### BACKGROUND

Electronic components in, for example, computing systems, electric vehicles, satellites, electronics, etc., are constantly improved in terms of size and performance. The performance of electronic systems is however often limited by the thermal management techniques available. Smaller components with higher power dissipation mean greater heat generation in smaller areas. As a result, more efficient thermal management is required for keeping the components within an appropriate temperature range. In other words, there is a growing need for increased efficiency, both in terms of volume requirements and energy.

One attempt to address these issues is with the use of electrohydrodynamic thermal management systems, in which an electrical field is used to create a flow in a dielectric fluid. This may prove more efficient than, for example, a traditional fan cooling. However, even though the EHD system offers thermal management by circulating a thermal management fluid in a relatively energy efficient manner, there is a need for an increased efficiency in EHD thermal management systems. An electrohydrodynamic thermal management system is for example disclosed in document US 4 396 055 A.

### SUMMARY

An object of the present invention is to provide a method of altering one or more properties of a dielectric fluid for use in an EHD thermal management system. The method is defined by the subject-matter of claim 1. The system may comprise at least one EHD pump unit comprising at least two electrodes for pumping the dielectric fluid, and an enclosure for accommodating the fluid within the system. The method may comprise the steps of exposing the dielectric fluid to an ionizing process configured to ionize the dielectric fluid, and to operate the pump unit to circulate or at least cause the exposed fluid to flow in the EHD system. For example, the ionizing process may comprise an ionizing irradiation of the dielectric fluid.

The dielectric fluid is exposed to the ionizing process in at least one of: a part of the enclosure, wherein a wall portion of the enclosure is exposed to the ionizing process, a location separated from the EHD thermal management system, from which the fluid is added to the EHD thermal management system after exposure, and within the enclosure, wherein the dielectric fluid is exposed to the ionizing process by a substance located within said enclosure.

The present invention is based on the realization that by exposing the dielectric fluid to an ionizing process configured to ionize the dielectric fluid, the pumping efficiency may be improved. This allows for an increased flow rate compared to non-ionized liquid, and thus a better cooling effect.

The proposed EHD system may comprise at least one pump unit that may be arranged within, or connected to, the enclosure in which the dielectric fluid is held. A cooling effect may be achieved by allowing the dielectric fluid to flow in order to transport heat energy away from the component, or area, in need of cooling. Similarly, a heating effect may be achieved by allowing the dielectric fluid to flow in order to transport heat energy to the component or region to be heated. In one example, the EHD system may be arranged to allow the dielectric fluid to circulate between a heat generating side of the system and a cooling side of the system, which for example may comprise a heat exchanger or heat sink.

The pump unit may be configured to create a flow in the fluid. The pump unit may comprise at least two electrodes, which may be separated from each other such that a second one of the electrodes is located in a downstream direction from a first one of the electrodes. The two electrodes may be connectable to a voltage source to create a field that affects the dielectric fluid such that a flow is created. The flow rate may be changed by varying the voltage applied to the electrodes. By decreasing the voltage, the fluid may lose momentum and the flow be decreased. Thus, by controlling the voltage, the cooling effect of the system can be adjusted.

Preferably, at least one of the electrode(s), such as the emitter electrode, may be elongated in the flow direction, such that a height as seen in the flow direction is greater than a width as seen in a directions orthogonal to the flow direction. This configuration may improve the electric field properties with respect to the corona discharge, which is believed to be the underlying mechanism accelerating the fluid between the electrodes.

By the term "ionizing process", it is here meant a process which is configured to ionize the dielectric fluid. More specifically, the ionizing process may encompass exposing the dielectric fluid to a radiation process that carries sufficient energy or is otherwise able to detach electrons from atoms or molecules. The ionizing process may comprise an ionizing irradiation of the dielectric fluid. The ionizing process may alternatively, or in combination with the (ir)radiation, comprise subjecting the dielectric fluid to one or more ionizing additives. Hence, without acquiescing to a particular physical model, exposing the dielectric fluid to an ionizing process is believed to cause the fluid to ionize and break down into other more easily ionizable chains of molecules. This altering of the characteristics of dielectric fluid may, when used in an EHD system, improve the pumping effect induced by the electrical field of the EHD unit and cause the fluid to flow at a higher velocity compared to what would have been achieved if the dielectric fluid were not exposed to such ionization process. The increased flow will in a thermal management system mean a greater cooling effect and improved power efficiency.

It will be appreciated that the dielectric fluid may be ionized at different stages of the EHD system's lifetime. Further, the ionization may also be carried out at different locations within or outside the EHD system. For example, the entire system, or only a part of it, such as the enclosure, could be exposed to a radiation from the outside, whilst the dielectric fluid is located within the system. In another example the dielectric fluid may be exposed to a radiation, or an ionizing additive, at a location separated from the enclosure and then added to the system at a later stage. Yet another example may be to add a small substance of radiating material, or an additive to the system, preferably within the enclosure, in order to expose the dielectric fluid to the ionization as it flows in the system. This may allow for the dielectric fluid to be exposed continuously, throughout the use of the system.

According to a second aspect of the invention, an EHD thermal management system comprising at least one pump unit is provided, configured in a manner as previously described. The system is defined by the subject-matter of claim 8. The system may comprise a dielectric fluid. The EHD thermal management system comprises at least two electrodes for pumping the dielectric fluid, and at least one enclosure for accommodating said dielectric fluid. The EHD thermal management system is configured to expose the dielectric fluid to an ionizing process configured to ionize the dielectric fluid.

The EHD system utilizes the characteristics of dielectric fluid exposed to the ionizing process. This may improve the pumping effect induced by the electrical field of the EHD unit and cause the fluid to flow at a higher velocity compared to what would have been achieved if the dielectric fluid was not exposed to such ionization process. The EHD thermal management system proposed may thus feature a greater cooling effect and an improved power efficiency. The ionizing process of the EHD system may comprise any steps of the ionizing process as previously described.

Thus, the first and second aspect of the present invention share a common general inventive concept or idea wherein dielectric fluid is exposed to an ionizing process.

By the term "dielectric fluid", it is here meant a dielectric material in a liquid or fluid state. Examples of dielectric fluids that can be pumped by means of embodiments of the invention may encompass 3M^{™} Novec^{™} (7000, 7100, 7200, 7500, 7700, 72DE, 71 DA), Galden^{®}HT (70, 110, 135, 72DE, 71DA), fluorinated fluids, hydrocarbon fluids, etc., or a combination thereof.

According to an embodiment of the present invention, the dielectric fluid may further comprise at least one additive. The additive may be in a fluid form or a solid form. For example, the additive may comprise a salt or any other form of ions which may be added to, and preferably dissolved in, the dielectric fluid. This may advantageously further increase the ionizing process of the dielectric fluid.

According to an embodiment of the present invention, the ionizing process comprises an ionizing irradiation of the dielectric fluid. It will be appreciated that in the present embodiment, the dielectric fluid may be ionized in an efficient manner and/or during a relatively long period of time. This may, for example, be advantageous in areas where a continuous exposure to an ionizing process is desired.

According to an embodiment of the present invention, the ionizing irradiation is generated from at least one radioactive isotope. The radioactive isotope may for example comprise, but is not limited to, Cobolt 60 or Americum. The ionizing (ir)radiation may further be generated from an electrically generated X-ray radiation. This is advantageous as the source of the ionizing radiation may be selected, for example, depending on the intended use, availability and/or cost efficiency. Furthermore, different radioactive isotopes may offer different levels of ionizing radiation and may thus be suitable in different systems. This may allow for a more accessible and cost-efficient system which furthermore may be customized for specific preconditions.

According to an embodiment of the present invention, the dielectric fluid is selected from the group consisting of a fluorinated fluid and a hydrocarbon fluid. The dielectric fluid may alternatively comprise a combination of the dielectric fluid as exemplified and other molecules or additives. It will be appreciated that combinations thereof may further increase the efficiency of the dielectric fluid in an EHD thermal management system.

According to an embodiment of the present invention, the enclosure may take the form of an enclosed passage, for example, defining a closed loop, adapted to convey a circulating flow of fluid. This specific configuration of the enclosure may be advantageous as the specific enclosure may provide a more efficient flow, as all fluid within the enclosure will be encouraged to move in the same direction.

According to an embodiment of the present invention, the pump unit is arranged in order to cover an entire cross-section of the closed loop configured enclosure. This is advantageous as a maximal amount of dielectric fluid in the given cross section will be subject to the pump unit, in other words, all fluid has to pass through the pump unit in order to circulate. As a result, an increased efficiency of the circulation of the dielectric fluid, and thus also the cooling effect, may be achieved. Further, the pump unit may not only be capable of inducing a flow in the dielectric fluid, but also to impede or even prevent the flow. In other words, the pump unit may be configured to operate as a switch capable of opening and closing the passage, which allows for an improved control of the flow.

According to an embodiment of the present invention, the at least two electrodes of the pump unit are arranged in a grid structure. For example, electrodes may be positioned either in a common plane or in different layers. Utilizing a grid structure may allow a further increase in the efficiency of the pump unit and allows for an increased control of the thermal management system.

### DETAILED DESCRIPTION OF THE DRAWINGS

A few example embodiments of the invention will be described for illustrative purposes in the following.

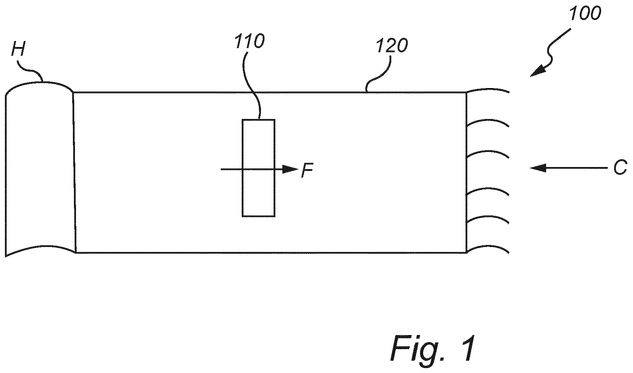

Figure 1 shows an EHD thermal management system 100 comprising a pump unit 110 and an enclosure 120 for dielectric fluid. Also displayed are a heat source H and a cooler area C, on opposite ends of the enclosure 120. A flow, F, is created by the pump unit 110, which in this embodiment may be located within the enclosure 120, where dielectric fluid is held. The flow F causes the dielectric fluid to circulate between the hot side H and the cooler area C so as to transport thermal energy from the heat source H towards the cooler area C.

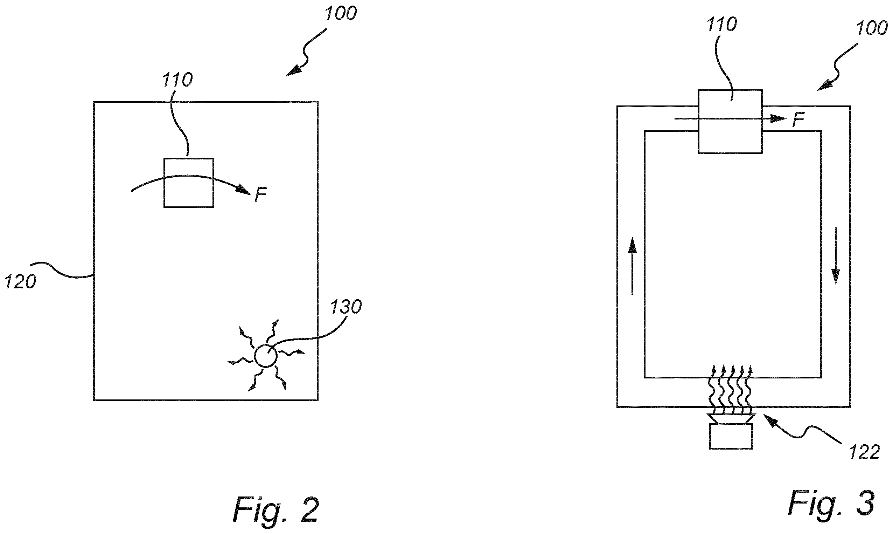

Figure 2 shows an EHD thermal management system 100 according to an embodiment. Here, the pump unit 110 and a device for exposing or subjecting the dielectric fluid to an ionizing process, exemplified as a radiation source 130, are located within the enclosure 120. The enclosure 120 is formed as a single chamber similar to the enclosure disclosed in figure 1. The pump unit 110 may be arranged to induce the flow F, preferably at a position relatively close or adjacent to a wall portion of the enclosure, to induce a motion or flow F of the fluid in a direction along the wall portion. The flowing dielectric fluid may be exposed to ionizing radiation 122 from the radiating source 130 located within the enclosure 120. The radiating source 130 may for example comprise a radioactive isotope such as Cobolt 60 or Americum. Other embodiments may utilize electrically generated X-ray radiation as an ionizing means. The setup with a radiating source 130 located within the enclosure may allow for the dielectric fluid to be continuously exposed to radiation 122 throughout the system's operation. This may result in increasing the lifespan of the irradiating effect on the dielectric fluid, and also providing EHD systems having a very long lifespan.

It should be noted that the dielectric fluid may be exposed to radiation at different points in time, locations, to a certain amount, or using different radiating source materials and dielectric fluids, and that the examples discussed with reference to the appended drawings merely are illustrative examples. According to some embodiments of the invention the fluid may be exposed to radiation separately from the EHD system and added to the system at a later stage. It will be appreciated that not the entire amount of said fluid has to be exposed to radiation. In some examples, exposed fluid could be added to the fluid in the EHD system, thus forming a radiated additive to the total amount of fluid in the system. It is also appreciated that the radiation may be provided from within the enclosure as well as from a source positioned outside the enclosure and/or the entire system. One example of such arrangement is disclosed in Figure 3.

Figure 3 depicts an embodiment in which the enclosure 120 is formed as a passage leading fluid through a closed loop. The enclosure 120 may e.g. be formed as a tube or channel wherein the end is connected to the beginning in order to allow for a continuous and repeated flow of a circulating fluid in a closed loop system.

The pump unit 110 may be arranged to cover an entire cross section of the enclosure 120, as indicated in Figure 3. Alternatively, the pump unit 110 may cover only a part of the cross section in order to allow fluid to pass at the side of the pump unit 100. By arranging the pump unit 110 to cover the entire cross section of the passage 120, all fluid has to pass through the pump unit 110 in order to circulate. As a result, the pump unit 110 may not only be capable of inducing a flow F in the dielectric fluid, but also to impede or even prevent the flow F. In other words, the pump unit 110 may be configured to operate as a switch capable of opening and closing the passage 120, which allows for an improved control of the flow.

As already mentioned, the irradiation 122 of the fluid may in this example be provided from outside of the system. As depicted, part of the enclosure may be subject to ionizing radiation 122, which may penetrate the wall of the enclosure and reach the dielectric fluid. Other embodiments may have the enclosure 120 exposed to radiation 122 in its entity. The radiating source 130 may be placed directly on the system or distanced from it.

## Claims

1. A method for altering one or more properties of a dielectric fluid for use in an electrohydrodynamic, EHD, thermal management system (100), the system comprising a radiating source, at least one EHD pump unit (110) comprising at least two electrodes for pumping the dielectric fluid and at least one enclosure (120) for accommodating the fluid within the system, the method comprising:
exposing the dielectric fluid to an ionizing irradiation (122) from the radiating source, wherein the ionizing irratiation is configured to ionize the dielectric fluid; and
operating the pump unit to circulate the exposed fluid in the enclosure;
wherein the dielectric fluid is exposed to the ionizing irradiation from the radiating source in at least one of:
a part of said enclosure, wherein a wall portion of the enclosure is exposed to said ionizing irradiation,
a location separated from said EHD thermal management system, from which the fluid is added to said EHD thermal management system after exposure, and
within said enclosure, wherein the dielectric fluid is exposed to the ionizing irradiation by a substance (130) located within said enclosure.

2. The method according to claim 1, wherein the ionizing irradiation is generated from at least one of a radioactive isotope and an electrically generated X-ray radiation.

3. The method according to any preceding claim, wherein the dielectric fluid is selected from the group consisting of a fluorinated fluid and a hydrocarbon fluid.

4. The method according to any preceding claim, wherein the dielectric fluid further comprises at least one additive.

5. The method according to any preceding claim, wherein the enclosure is formed as an enclosed passage adapted to convey a circulating flow of the fluid.

6. The method according to claim 5, wherein the pump unit is arranged to cover an entire cross section of the passage.

7. The method according to any preceding claim, wherein the at least two electrodes are formed as grid structures.

8. An electrohydrodynamic, EHD, thermal management system (100) comprising a radiating source, at least one pump unit (110) comprising at least two electrodes for pumping a dielectric fluid, and at least one enclosure (120) for accommodating said dielectric fluid, wherein the EHD thermal management system is configured to expose the dielectric fluid to an ionizing irradiation (122) from the radiating source configured to ionize the dielectric fluid.

9. The EHD thermal management system according to claim 8, wherein the dielectric fluid is exposed to the ionizing irradiation from the radiating source in at least one of:
a part of said enclosure, wherein a wall portion of the enclosure is exposed to said ionizing irradiation,
a location separated from said EHD thermal management system, from which the fluid is added to said EHD thermal management system after exposure, and
within said enclosure, wherein the dielectric fluid is exposed to the ionizing irradiation by a substance (130) located within said enclosure.

10. The EHD thermal management system according to claim 9, wherein the ionizing irradiation is generated from at least one of a radioactive isotope and an electrically generated X-ray radiation.

11. The EHD thermal management system according to any of claims 8-10, wherein the dielectric fluid is selected from the group consisting of a fluorinated fluid and a hydrocarbon fluid.

12. The EHD thermal management system according to any of claims 8-11, wherein the dielectric fluid further comprises at least one additive.

13. The EHD thermal management system according to any of claims 8-12, wherein the enclosure is formed as an enclosed passage adapted to convey a circulating flow of the fluid.

14. The EHD thermal management system according to claim 13, wherein the pump unit is arranged to cover an entire cross section of the passage.

15. The EHD thermal management system according to any of claims 8-14, wherein the at least two electrodes are formed as grid structures.

## Patentansprüche

1. Verfahren zum Verändern einer oder mehrerer Eigenschaften eines dielektrischen Fluids zur Verwendung in einem elektrohydrodynamischen, EHD, Wärmemanagementsystem (100), wobei das System eine Strahlungsquelle, wenigstens eine EHD-Pumpeneinheit (110), die wenigstens zwei Elektroden umfasst, zum Pumpen des dielektrischen Fluids und wenigstens eine Umschließung (120) zur Aufnahme des Fluids in dem System umfasst, wobei das Verfahren umfasst:
Exponieren des dielektrischen Fluids gegenüber einer ionisierenden Strahlung (122) aus der Strahlungsquelle, wobei die ionisierende Strahlung dafür gestaltet ist, das dielektrische Fluid zu ionisieren; und
Betreiben der Pumpeneinheit, um das exponierte Fluid in der Umschließung zu zirkulieren;
wobei das dielektrische Fluid gegenüber der ionisierenden Strahlung aus der Strahlenquelle exponiert wird in/an wenigstens einem von:
einem Teil der Umschließung, wobei ein Wandabschnitt der Umschließung gegenüber der ionisierenden Strahlung exponiert wird,
einem Ort getrennt von dem EHD-Wärmemanagementsystem, von wo das Fluid nach Exposition zu dem EHD-Wärmemanagementsystem zugegeben wird, und
innerhalb der Umschließung, wobei das dielektrische Fluid durch einen innerhalb der Umschließung angeordneten Stoff (130) gegenüber der ionisierenden Strahlung exponiert wird.

2. Verfahren gemäß Anspruch 1, wobei die ionisierende Strahlung von wenigstens einem von einem radioaktiven Isotop und einer elektrisch erzeugten Röntgenstrahlung erzeugt wird.

3. Verfahren gemäß einem der vorstehenden Ansprüche, wobei das dielektrische Fluid ausgewählt ist aus der Gruppe bestehend aus einem fluorierten Fluid und einem Kohlenwasserstofffluid.

4. Verfahren gemäß einem der vorstehenden Ansprüche, wobei das dielektrische Fluid ferner wenigstens einen Zusatzstoff umfasst.

5. Verfahren gemäß einem der vorstehenden Ansprüche, wobei die Umschließung als ein umschlossenen Durchlass gestaltet ist, der zum Befördern eines zirkulierenden Stroms des Fluids ausgelegt ist.

6. Verfahren gemäß Anspruch 5, wobei die Pumpeneinheit dafür gestaltet ist, einen gesamten Querschnitt des Durchlasses zu bedecken.

7. Verfahren gemäß einem der vorstehenden Ansprüche, wobei die wenigstens zwei Elektroden als Gitterstrukturen gestaltet sind.

8. Elektrohydrodynamisches, EHD, Wärmemanagementsystem (100), umfassend eine Strahlungsquelle, wenigstens eine Pumpeneinheit (110), die wenigstens zwei Elektroden umfasst, zum Pumpen eines dielektrischen Fluids und wenigstens eine Umschließung (120) zur Aufnahme des dielektrischen Fluids, wobei das EHD-Wärmemanagementsystem dafür gestaltet ist, das dielektrische Fluid gegenüber einer ionisierenden Strahlung (122) aus der Strahlungsquelle, gestaltet zum Ionisieren des dielektrischen Fluids, zu exponieren.

9. EHD-Wärmemanagementsystem gemäß Anspruch 8, wobei das dielektrische Fluid gegenüber der ionisierenden Strahlung aus der Strahlungsquelle exponiert wird in/an wenigstens einem von:
einem Teil der Umschließung, wobei ein Wandabschnitt der Umschließung gegenüber der ionisierenden Strahlung exponiert wird,
einem Ort getrennt von dem EHD-Wärmemanagementsystem, von wo das Fluid nach Exposition zu dem EHD-Wärmemanagementsystem zugegeben wird, und
innerhalb der Umschließung, wobei das dielektrische Fluid durch einen innerhalb der Umschließung angeordneten Stoff (130) gegenüber der ionisierenden Strahlung exponiert wird.

10. EHD-Wärmemanagementsystem gemäß Anspruch 9, wobei die ionisierende Strahlung von wenigstens einem von einem radioaktiven Isotop und einer elektrisch erzeugten Röntgenstrahlung erzeugt wird.

11. EHD-Wärmemanagementsystem gemäß einem der Ansprüche 8-10, wobei das dielektrische Fluid ausgewählt ist aus der Gruppe bestehend aus einem fluorierten Fluid und einem Kohlenwasserstofffluid.

12. EHD-Wärmemanagementsystem gemäß einem der Ansprüche 8-11, wobei das dielektrische Fluid ferner wenigstens einen Zusatzstoff umfasst.

13. EHD-Wärmemanagementsystem gemäß einem der Ansprüche 8-12, wobei die Umschließung als ein umschlossenen Durchlass gestaltet ist, der zum Befördern eines zirkulierenden Stroms des Fluids ausgelegt ist.

14. EHD-Wärmemanagementsystem gemäß Anspruch 13, wobei die Pumpeneinheit dafür gestaltet ist, einen gesamten Querschnitt des Durchlasses zu bedecken.

15. EHD-Wärmemanagementsystem gemäß einem der Ansprüche 8-14, wobei die wenigstens zwei Elektroden als Gitterstrukturen gestaltet sind.

## Revendications

1. Procédé destiné à modifier une ou plusieurs propriétés d'un fluide diélectrique à utiliser dans un système (100) de gestion thermique électrohydrodynamique, EHD, le système comprenant une source de rayonnement, au moins une unité de pompage EHD (110) comprenant au moins deux électrodes pour pomper le fluide diélectrique et au moins une enceinte (120) pour accueillir le fluide à l'intérieur du système, le procédé comprenant :
l'exposition du fluide diélectrique à une irradiation ionisante (122) depuis la source de rayonnement, l'irradiation ionisante étant configurée pour ioniser le fluide diélectrique ; et
le fonctionnement de l'unité de pompage pour faire circuler le fluide exposé dans l'enceinte ;
dans lequel le fluide diélectrique est exposé à l'irradiation ionisante depuis la source de rayonnement à au moins un endroit parmi :
une partie de ladite enceinte, une partie de paroi de l'enceinte étant exposée à ladite irradiation ionisante,
un emplacement séparé dudit système de gestion thermique EHD, depuis lequel le fluide est ajouté audit système de gestion thermique EHD après exposition, et
à l'intérieur de ladite enceinte, le fluide diélectrique étant exposé à l'irradiation ionisante par une substance (130) située à l'intérieur de ladite enceinte.

2. Procédé selon la revendication 1, dans lequel l'irradiation ionisante est générée à partir d'un isotope radioactif et/ou d'un rayonnement de rayons X généré électriquement.

3. Procédé selon une quelconque revendication précédente, dans lequel le fluide diélectrique est choisi dans le groupe constitué par un fluide fluoré et un fluide hydrocarboné.

4. Procédé selon une quelconque revendication précédente, dans lequel le fluide diélectrique comprend en outre au moins un additif.

5. Procédé selon une quelconque revendication précédente, dans lequel l'enceinte est formée comme un passage fermé adapté pour transporter un flux circulant du fluide.

6. Procédé selon la revendication 5, dans lequel l'unité de pompage est agencée pour couvrir une section transversale entière du passage.

7. Procédé selon une quelconque revendication précédente, dans lequel les au moins deux électrodes sont formées comme des structures de grille.

8. Système (100) de gestion thermique électrohydrodynamique, EHD, comprenant une source de rayonnement, au moins une unité de pompage (110) comprenant au moins deux électrodes pour pomper un fluide diélectrique, et au moins une enceinte (120) pour accueillir ledit fluide diélectrique, le système de gestion thermique EHD étant configuré pour exposer le fluide diélectrique à une irradiation isolante (122) depuis la source de rayonnement configurée pour ioniser le fluide diélectrique.

9. Système de gestion thermique EHD selon la revendication 8, dans lequel le fluide diélectrique est exposé à l'irradiation ionisante depuis la source de rayonnement à au moins un endroit parmi :
une partie de ladite enceinte, une partie de paroi de l'enceinte étant exposée à ladite irradiation ionisante,
un emplacement séparé dudit système de gestion thermique EHD, depuis lequel le fluide est ajouté audit système de gestion thermique EHD après exposition, et
à l'intérieur de ladite enceinte, le fluide diélectrique étant exposé à l'irradiation ionisante par une substance (130) située à l'intérieur de ladite enceinte.

10. Système de gestion thermique EHD selon la revendication 9, dans lequel l'irradiation ionisante est générée à partir d'un isotope radioactif et/ou d'un rayonnement de rayons X généré électriquement.

11. Système de gestion thermique EHD selon l'une quelconque des revendications 8 à 10, dans lequel le fluide diélectrique est choisi dans le groupe constitué par un fluide fluoré et un fluide hydrocarboné.

12. Système de gestion thermique EHD selon l'une quelconque des revendications 8 à 11, dans lequel le fluide diélectrique comprend en outre au moins un additif.

13. Système de gestion thermique EHD selon l'une quelconque des revendications 8 à 12, dans lequel l'enceinte est formée comme un passage fermé adapté pour transporter un flux circulant du fluide.

14. Système de gestion thermique EHD selon la revendication 13, dans lequel l'unité de pompage est agencée pour couvrir une section transversale entière du passage.

15. Système de gestion thermique EHD selon l'une quelconque des revendications 8 à 14, dans lequel les au moins deux électrodes sont formées comme des structures de grille.
